Europäisches Patentamt

European Patent Office

Office européen des brevets

(11) Publication number: **0 346 543**
**A1**

# (12) EUROPEAN PATENT APPLICATION

(21) Application number: **88305468.6**

(22) Date of filing: **15.06.88**

(51) Int. Cl.⁴: **H01L 21/285 , H01L 29/40**

(43) Date of publication of application:
**20.12.89 Bulletin 89/51**

(84) Designated Contracting States:
**AT BE CH DE FR IT LI LU NL SE**

(71) Applicant: **BRITISH TELECOMMUNICATIONS public limited company**
**81 Newgate Street**
**London EC1A 7AJ(GB)**

(72) Inventor: **Welbourn, Anthony David**
**7 Fishbane Close**
**Ipswich Suffolk, IP3 OSE(GB)**
Inventor: **Heslop, Christopher John**
**7 Viking Heights Martlesham**
**Woodbridge Suffolk, IP12 4RT(GB)**

(74) Representative: **Pratt, David Martin et al**
**Intellectual Property Unit British Telecom**
**151 Gower Street**
**London WC1E 6BA(GB)**

(54) **Bipolar transistor.**

(57) A bipolar transistor has a polysilicon emitter contact (7), the polysilicon essentially filing the emitter window (5), and having a substantially planar upper surface. The planar upper surface of the emitter contact (7) eases subsequent metal deposition and patterning, and also results in a more nearly planar dopant drive front when the polysilicon is used as a dopant source in forming a shallow ( 0.1 um) emmiter (12).

Fig.3.

Fig.1.

Fig.5.

EP 0 346 543 A1

# BIPOLAR TRANSISTOR

The present invention relates to a bipolar transistor, and in particular to the configuration of a polysilicon emitter contact for such a transistor.

The continuing reduction in size of bipolar transistors in bipolar microcircuits has forced the abandonment of direct metal emitter contacts for small (that is to say those having emitter widths of less than 3 um) devices. The reason for the abandonment of metal for emitter contacts is that metal gives rise to a high recombination velocity at the emitter surface. The use of polysilicon for emitter contacts results in a much lower recombination velocity, making it possible to produce good shallow emitters. A further reason for abandoning metal emitter contacts is that, as the size of the emitter window is reduced, a point is reached where the metal, which does not deposit conformally, no longer penetrates adequately the emitter window, so that it becomes impossible to ensure reliable and repeatable contact with the emitter.

Unlike metal, polycrystalline silicon (polysilicon) deposits conformally and is, therefore, better able to coat the sidewalls and floor of the emitter window (the site of the emitter contact) uniformly. Unfortunately, although it is possible to achieve good contact between polysilicon and the emitter, the conductivity of polysilicon is much less than that of metal, even when the former is heavily doped (at the saturation limit of about $1E21$ cm$^{-3}$). Since the principal reason for reducing transistor size is to increase the speed of operation, and since resistance in series with the emitter effectively reduces the transistor's transconductance, thereby reducing the slew rate, it is important that the thickness of the polysilicon in the emitter contact is kept to a minimum (without being "transparent" to charge carriers such that the recombination velocity at the emitter surface rises). Again, since polysilicon deposits conformally, it is relatively easy to deposit a satisfactory thin polysilicon layer to which contact can be made by subsequent metallisation.

Although such an arrangement works relatively well for emitter widths of about 3 $\mu$m, a number of problems become increasingly more severe as the emitter width is reduced further. In order to be able to define the required small feature sizes with the necessary tight tolerances, it becomes essential to use anisotropic etching processes, such as plasma etching, in place of the isotropic (usually wet) etching processes used formerly. A result of this is that the emitter sidewalls, and other "vertical" features, are likely to be substantially normal to the wafer plane rather than inclined at between 45° and 60° to the wafer plane as they were formerly. Additionally, the height of the emitter window increases with reduced emitter size, particularly with self-aligned processes.

Unfortunately, the problem of providing satisfactory metallisation of the emitter window sidewalls becomes increasingly more serious as these sidewalls become taller and steeper. Furthermore, even if a metal layer free from defects can be produced, its uneven surface will mean that it cannot readily be patterned using optical lithography, since, at the feature size of interest, the depth of field of the imaging optics is very shallow.

A further problem manifests itself when the polysilicon emitter contact is used as a dopant source for the production of a shallow diffused emitter. When a shallow diffused emitter is to be formed, the polysilicon is heavily doped with a dopant species such as arsenic by implantation. Unfortunately, as the width of the emitter window is reduced, the proportion of the emitter width which is under the polysilicon formed against the window walls increases, and the thickness of polysilicon normal to the wafer surface increases as the inclination and height of the sidewalls increase, so that, during the dopant drive, a very non-uniform dopant front can be formed. The result of this non-uniformity is that the base thickness varies considerably across the width of the emitter, to the detriment of device performance.

The aim of the invention is to provide a method of forming a polysilicon emitter contact for a bipolar transistor which does not have the disadvantages of the prior art method.

The present invention provides a method of fabricating a bipolar transistor having a polysilicon emitter contact, the method comprising the steps of

a) forming an emitter window in a dielectric layer to expose underlying semiconductor within an active region;

b) depositing polysilicon over the dielectric layer to fill the emitter window; and

c) planarising the surface of the polysilicon; wherein the polysilicon is conformally deposited until the coatings on the sidewalls of the emitter window meet.

Advantageously, the emitter window has a minimum width of no more than 1.5 $\mu$m. Preferably, after planarisation, the thickness of polysilicon on the active region is at least 0.3 $\mu$m.

The method may further comprise the steps of implanting a dopant species into the planarised polysilicon, and forming an emitter by driving the dopant species into the semiconductor of the active region.

The invention also provides bipolar transistor whenever made according to the method defined above.

The invention further provides a bipolar transistor having a polysilicon emitter contact, wherein the surface of the polysilicon emitter contact which is remote from the active region of the transistor, and which overlies the floor of the emitter window, is essentially planar.

The invention will now be described in greater detail, by way of example, with reference to accompanying drawings, in which:

Figure 1 is a schematic cross-section through a semiconductor wafer, showing the emitter window of a bipolar transistor constructed in accordance with the invention prior to formation of an emitter contact;

Figure 2 shows a conventional polysilicon emitter contact;

Figure 3 shows the emitter window of Figure 1 filled with polysilicon;

Figure 4 shows the emitter window of Figure 3 after the polysilicon has been planarised; and

Figure 5 shows the emitter window of Figure 4 after the emitter contact has been cut, and a shallow emitter formed.

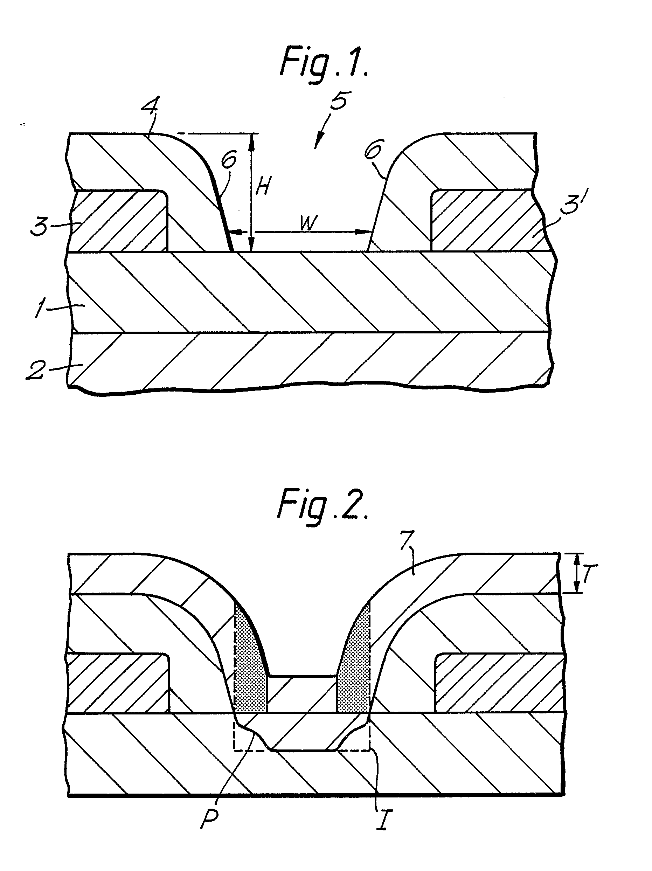

Referring to the drawings, Figure 1 shows a base region 1 which is formed by doping in a body of semiconductor 2 on a wafer substrate. Polysilicon base contacts 3, 3′ are formed on the base region 2, and are covered with a dielectric layer 4 which may be oxide. An emitter window 5 is then formed in the dielectric layer 4 to expose the surface of the base region 1. The width W of the emitter window 5 is preferably less than 1.5 um, and more preferably less than 1.0 um. The height H of the emitter window 5 is typically between 0.5 and 1.0 um. As a result of the use of an anisotropic etching process, such as plasma etching or some other dry process, which is necessary for for accurate definition of the emitter window 5 and its position, the walls 6 of the emitter window will be substantially normal to the surface of the wafer, although the upper end of the window will tend to have an outward taper due to erosion of the mask used during etching.

A conventional polysilicon emitter contact formed in a conventional emitter window comprises a conformal polysilicon layer 7 (see Figure 2) deposited to a thickness T of between about 0.2 and 0.4 um, the polysilicon forming a thin layer of a "gull-wing" configuration covering the floor and sidewalls of the window. If such a configuration is used when a shallow emitter is formed by driving dopant from the polysilicon 7, the problem of non-uniformity in the doping front becomes severe when the polysilicon, which covers the floor of the emitter window, and from which dopant will be driven into the base region, varies appreciably in height. In the example shown, the shaded region signifies the relevant polysilicon. As can be seen, at the periphery of the window, the polysilicon has a height which is about 3 to 4 times that in the centre of the window. The effect of such a polysilicon profile on the doping profile of an emitter diffused from it can be seen by comparing the predicted profile P with the ideal profile I shown in Figure 2.

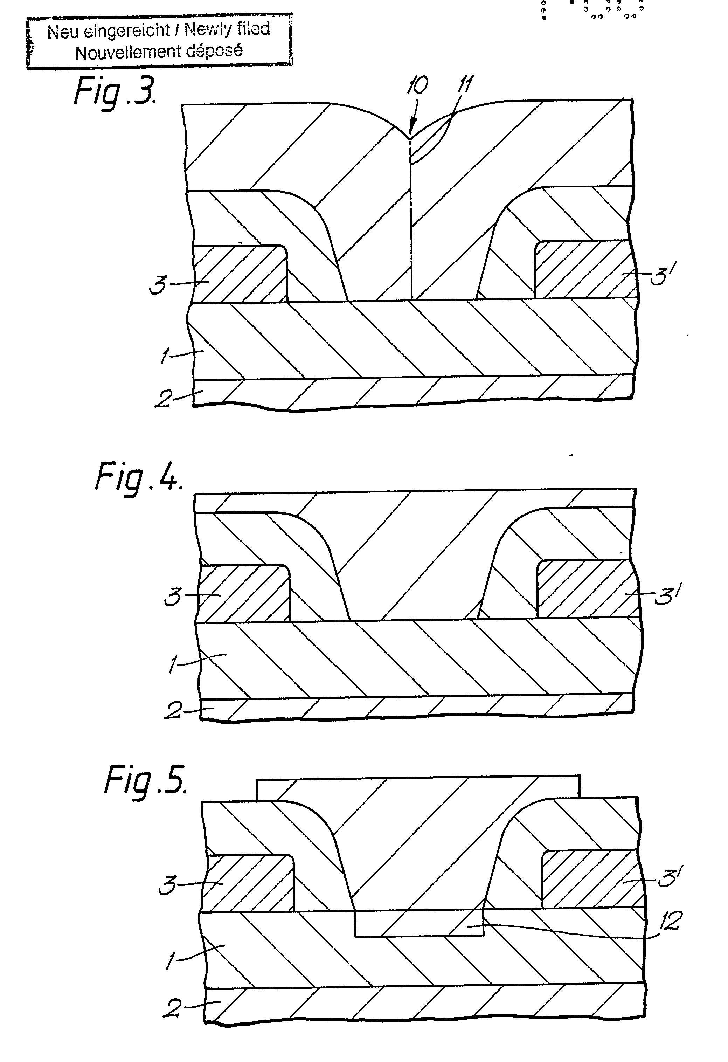

In the method according to the invention, the polysilicon 7 (see Figure 3) is deposited to a greater initial thickness, so that the emitter window 5 is substantially, or more preferably completely, filled. Deposition of the polysilicon 7 is continued until the conformal coatings on opposed parts of the window sidewalls 6 grow together. In practice, a realistic upper limit on the minimum emitter window width is 1.5 um, since above this limit an excessive thickness of polysilicon 7 needs to be deposited in order to fill the window 5. As a consequence of the original profile of sidewalls 6 of the emitter window 5, there will generally be a slight depression 10 in the surface of the polysilicon 7 where the coatings of the sidewalls meet, as shown in Figure 3. The line 11, along which the coatings from the major sidewalls 6 meet, may also be marked by a concentration of grain boundaries, although in practice the grain boundaries will tend to be largely eliminated during dopant implantation.

Whe the emitter window 5 has been filled, the polysilicon 7 is planarised using an appropriate planarising layer, such as photoresist, and a planarising etch. Preferably, the etching is continued until only about 1000-2000A of polysilicon 7 remains over the oxide 4 flanking the emitter window, as shown in Figure 4.

The polysilicon 7 is then heavily doped (in excess of the solid solubility limit) to about 1-$2 \times 10^{16} cm^{-2}$, typically with arsenic. The lateral extent of the emitter polysilicon 7 is then defined lithographically. The polysilicon 7 is then capped, with for example an oxide of silicon, to prevent out diffusion of arsenic during subsequent processing. An emitter 12 is then formed by heating, preferably using rapid thermal annealing for at least a few seconds at 1050-1150°C, to drive dopant from the polysilicon 7 into the base region 1.

Further processing is conventional. If oxide was used for the capping layer, it may be left in place to be covered by the dielectric which is subsequently deposited.

It is possible to reduce the thickness, and hence the resistance, of the polysilicon 7 between the emitter metal and the emitter 12 by siliciding the upper part of the polysilicon. Preferably, if silicide is used, the planarising etch of the polysilicon 7 is continued until the polysilicon surface is about 1000-2000Å beneath the surface of the oxide 4 which flanks the emitter window 5. The polysilicon 7 is then heavily doped and as before annealed, using for example a nitride capping layer which is subsequently removed. A metal suitable for siliciding, for example titanium, is then deposited over the surface of the structure and reacted with the polysilicon 7. After siliciding, the unreacted metal is "washed" away by etching. The emitter metal is then formed over the silicide and defined with conventional lithography.

## Claims

1. A method of fabricating a bipolar transistor having a polysilicon emitter contact (7), the method comprising the steps of
   a) forming an emitter window (5) in a dielectric layer (4) to expose underlying semiconductor (2) within an active region;
   b) depositing polysilicon (7) over the dielectric layer (4) to fill the emitter window (5); and
   c) planarising the surface of the polysilicon (7); wherein the polysilicon (7) is conformally deposited until the coatings on the sidewalls (6) of the emitter window (5) meet.

2. A method as claimed in claim 1, wherein the emitter window (5) has a minimum width of no more than 1.5 um.

3. A method as claimed in claim 1 or claim 2, wherein, after planarisation, the thickness of polysilicon (7) on the active region is at least 0.3 um.

4. A method as claimed in any one of claims 1 to 3, further comprising the steps of implanting a dopant species into the planarised polysilicon (7), and forming an emitter (12) by driving the dopant species into the semiconductor (2) of the active region.

5. A bipolar transistor whenever made according to the method of any one of claims 1 to 4.

6. A bipolar transistor having a polysilicon emitter contact (7) wherein the surface of the polysilicon emitter contact (7) which is remote from the active region of the transistor, and which overlies the floor of the emitter window (5), is essentially planar.

7. A bipolar transistor as claimed in claim 6, wherein the polysilicon emitter contact (7) has a thickness under said surface of at least 0.3 um.

## Fig.1.

## Fig.2.

Fig .3.

3 — 3'

1

2

Fig .4.

3 — 3'

1

2

Fig .5.

3 — 3'

1

2

12

10 11

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 4) |
|---|---|---|---|
| Y | PATENT ABSTRACTS OF JAPAN, vol. 10, no. 329 (E-452)[2385], 8th November 1986; & JP-A-61 136 267 (NEC CORP.) 24-06-1986 * Abstract * | 1-7 | H 01 L 21/285 H 01 L 29/40 |
| Y | EP-A-0 170 544 (COMMISSARIAT A L'ENERGIE ATOMIQUE) * Figures 5-8; page 6, line 33 - page 9, line 4 * | 1-7 | |
| A | EP-A-0 260 058 (BRITISH TELECOMMUNICATIONS PLC) * Column 1, lines 42-51; figure 4 * | 2 | |
| X | EP-A-0 252 206 (HITACHI LTD) * Figure 6; column 17, lines 5-29; column 6, lines 9-21 * | 6,7 | |
| X | US-A-4 745 087 (A. IRANMANESH) * Figures 10-12; column 6, line 45 - column 7, line 2 * | 6 | TECHNICAL FIELDS SEARCHED (Int. Cl.4) |
| A | IBM TECHNICAL DISCLOSURE BULLETIN, vol. 25, no. 2, July 1982, pages 612-617, New York, US; C.G. JAMBOTKAR: "Superior-performance NPN transistors and polysilicon resistors" * Whole article, especially figures 13,14 * | 1,2,5,6 | H 01 L |

The present search report has been drawn up for all claims

| Place of search | Date of completion of the search | Examiner |
|---|---|---|
| THE HAGUE | 14-02-1989 | MACHEK, J. |